Europäisches Patentamt

European Patent Office

Office européen des brevets

(19)

(11) Publication number: **0 227 381 B1**

# EUROPEAN PATENT SPECIFICATION

(12)

(45) Date of publication of patent specification: **18.09.91**   (51) Int. Cl.⁵: **H01L 27/10**, G11C 11/24

(21) Application number: **86309624.4**

(22) Date of filing: **10.12.86**

(54) Semiconductor memory device.

(30) Priority: **13.12.85 JP 282264/85**
          **18.12.85 JP 285163/85**

(43) Date of publication of application:
     **01.07.87 Bulletin 87/27**

(45) Publication of the grant of the patent:
     **18.09.91 Bulletin 91/38**

(84) Designated Contracting States:
     **DE FR GB**

(56) References cited:
     **GB-A- 2 114 814**

     **PATENTS ABSTRACTS OF JAPAN, vol. 6, no.
     6 (E-89)[884], 14th January 1982; & JP-A-56
     129 367**

     **PATENTS ABSTRACTS OF JAPAN, vol. 5, no.
     34 (E-48)[706], 4th March 1981; & JP-A-55 160
     463**

     **IBM TECHNICAL DISCLOSURE BULLETIN, vol.
     27, no. 7B, December 1984, pages 4463-4464,
     New York, US; R.E. SCHEUERLEIN: "Very thin
     dielectric storage cap in N-skin compatible
     process"**

(73) Proprietor: **MITSUBISHI DENKI KABUSHIKI
     KAISHA**
     **2-3, Marunouchi 2-chome Chiyoda-ku
     Tokyo 100(JP)**

(72) Inventor: **Sato, Shinichi c/o Mitsubishi Denki
     K.K. LSI**
     **Kenkyusho 1 Mizuhara 4-chome
     Itami-shi Hyogo-ken(JP)**
     Inventor: **Tokui, Akira c/o Mitsubishi Denki
     K.K. LSI**
     **Kenkyusho 1 Mizuhara 4-chome
     Itami-shi Hyogo-ken(JP)**
     Inventor: **Kawai, Akira c/o Mitsubishi Denki
     K.K. LSI**
     **Kenkyusho 1 Mizuhara 4-chome
     Itami-shi Hyogo-ken(JP)**
     Inventor: **Nakajima, Masayuki c/o Mitsubishi
     Denki K.K. LSI**
     **Kenkyusho 1 Mizuhara 4-chome
     Itami-shi Hyogo-ken(JP)**
     Inventor: **Nagatomo, Masao c/o Mitsubishi De-
     nki K.K. LSI**
     **Kenkyusho 1 Mizuhara 4-chome
     Itami-shi Hyogo-ken(JP)**

Inventor: **Ozaki, Hiroji c/o Mitsubishi Denki K.K. LSI**
**Kenkyusho 1 Mizuhara 4-chome**
**Itami-shi Hyogo-ken(JP)**

(74) Representative: **Beresford, Keith Denis Lewis et al**
**BERESFORD & Co. 2-5 Warwick Court High Holborn**
**London WC1R 5DJ(GB)**

## Description

The present invention relates to a semiconductor memory device and particularly to an improvement in a structure of a capacitor portion and other portions constituting a semiconductor memory device.

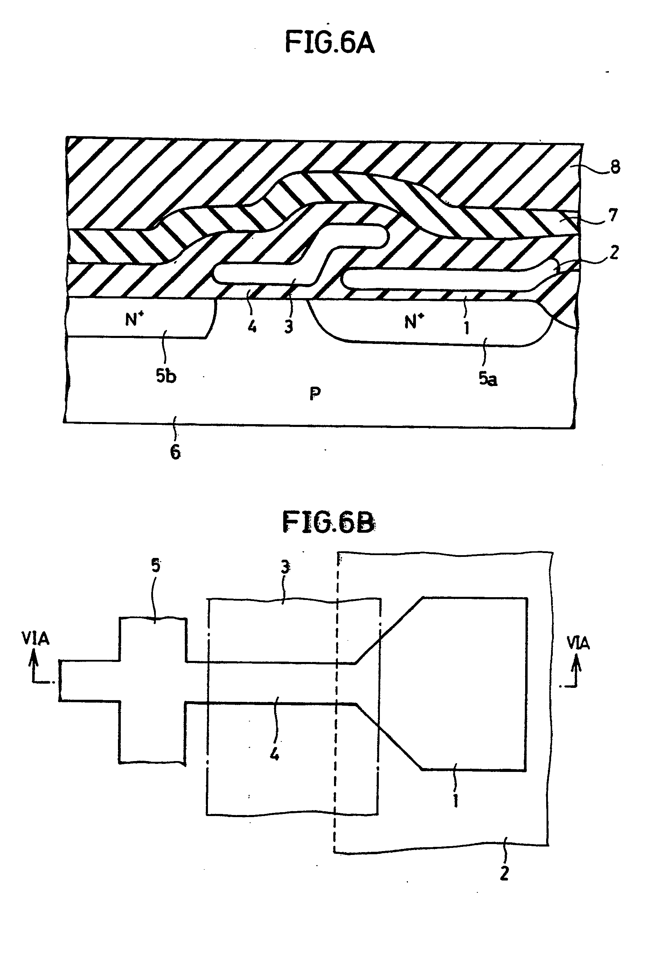

Conventionally, a single-transistor single-capacitor structure is adopted for a memory cell in a MOS dynamic RAM. An example of a memory cell of this type is described in "New Physical Mechanism for Soft Error in Dynamic Memories" by T.C. May in Proc. 1978, International Reliability Physics Symposium, pp. 30-40, 1978. An outline of the structure of the memory cell described in this document is shown in Figs. 6A and 6B. Fig. 6A is a sectional view of a plane pattern of the memory cell shown in Fig. 6B taken along the line VIA-VIA. Referring to Figs. 6A and 6B, the memory cell comprises a silicon oxide film 1 of a capacitor portion, a first polysilicon layer 2, a second polysilicon layer 3, a gate oxide film 4 of a transistor, an impurity diffusion region 5 serving as a bit line, and a P type silicon substrate 6. In this memory cell, generally, power supply voltage is applied to the first polysilicon layer 2 and, the capacitor formed by the first polysilicon layer 2, the silicon oxide film 1 and a channel produced in an $N^+$ impurity diffusion region 5a located immediately under the oxide film 1 is used as the memory cell while another $N^+$ impurity diffusion region 5b is used as the bit line.

The thus structured memory cell tends to have a reduced area according to the recent demand for large-scale integration. For example, the area of a memory cell in a 16K-bit RAM is approximately $400\mu m^2$, while the area of a memory cell in a 64K-bit RAM is reduced to approximately $200\mu m^2$. In order to prevent decrease of capacitance due to reduction of the memory cell area, a method of decreasing the thickness of the silicon oxide film 1 or a similar method is adopted. However, the amount of stored electric charge is decreased because of decrease of power supply voltage applied. In consequence, so-called soft errors become a serious problem. Soft errors include erasure of the stored content in memory or erroneous operation and arise when $\alpha$ rays applied to a memory cell chip bring about diffusion of electron-hole pairs in the silicon substrate 6 to make them recouple with electric charge stored in the memory cell or with electric charge in the bit line.

As means for preventing such errors, there is proposed, as shown in Fig. 6A, means for preventing particles from entering the substrate 6, by forming a coating film 8 of several tens of $\mu m$ in thickness formed of polyimide for example on a passivation film 7. However, such means involves increases in the manufacturing steps, the manufacturing cost etc. and therefore it is not suited for practical use.

An alternative approach to reducing soft error is disclosed in Patents Abstracts of Japan Vol. 6, no. 6(E-89) (1984), 14th January 1982; JP-A-56 129 367 (Mitsubishi Denki KK). As discussed with reference to Fig. 2 therein a single FET transistor - single capacitor memory cell element, otherwise of conventional structure, is modified by surrounding the source and drain diffused regions of the transistor by regions that are of higher impurity concentration but of the same conductivity type as that of the substrate.

The present invention is intended to provide a remedy.

The above change of transistor characteristics is found to arise as a result of the close proximity of the added surrounding regions located laterally each side of the transistor channel.

Accordingly, it is a feature characterising the present invention that the plane areas of the added high concentration impurity regions are smaller than, and do not extend beyond, the corresponding plane areas of the transistor diffusions beneath which they are located, respectively.

With this arrangement it is found that significant modification of the transistor characteristics is avoided whilst adequate immunity of soft error is still provided.

This and other advantages of the invention will be made apparent in the description given below when taken in conjunction with the following drawings that accompany this specification.

Fig. 1A is a view showing a partial sectional structure of a semiconductor memory device;

Fig. 1B is a partial plan view of a semiconductor memory device;

Fig. 2 is a graph showing a concentration profile of a PN junction;

Fig. 3 to 5 are structural views showing examples of a memory cell contained in a package;

Fig. 6A is a sectional view showing a conventional semiconductor memory device; and

Fig. 6B is a plan view of a conventional semiconductor memory device.

Preferred embodiments will be described now and reference will be made to the drawings. The description that follows is given by way of example only.

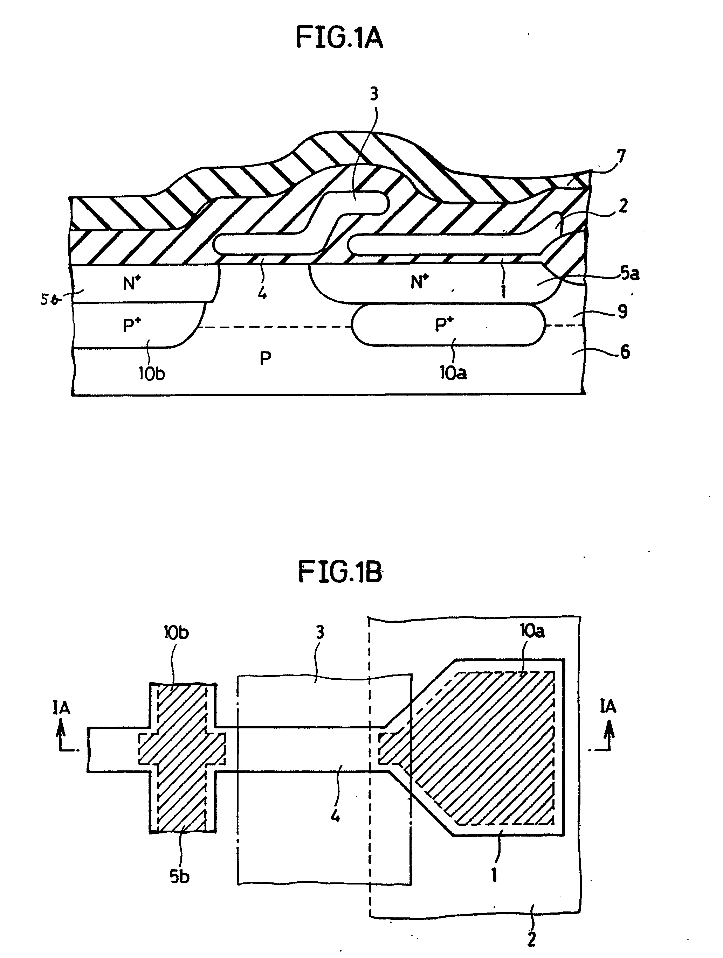

Figs. 1A and 1B are views showing a structure of a semiconductor memory device, an embodiment of the present invention. Particularly, Fig. 1B is a view of a plane pattern of a memory cell portion included in a semiconductor memory device and Fig. 1A is a sectional view taken along the line IA-IA of Fig. 1B.

The semiconductor memory device shown comprises a P type silicon substrate 6, a substrate surface portion 9 formed by vapor growth on the upper portion of the silicon substrate 6, and $N^+$ impurity diffusion regions 5a and 5b, the region 5b functioning as a bit line and the region 5a functioning mainly as a charge storage region of a memory cell. This embodiment further comprises a second polysilicon layer 3 functioning as a gate electrode of a transistor, and a gate oxide film 4 of the transistor. It further comprises a first polysilicon layer 2 functioning as a capacitor electrode and a silicon oxide film 1 of a memory cell capacitor portion. A passivation film 7 is formed as the uppermost portion of the memory cell portion.

It will be noted particularly that $p^+$ high concentration impurity layers 10a and 10b constituting PN junction with the $N^+$ regions 5a and 5b, respectively, are formed under the $N^+$ region 5a as the charge storage region and under the $N^+$ region 5b as the bit line, respectively. The respective plane areas of the $P^+$ high intensity impurity layers 10a and 10b are made smaller than the respective plane areas of the $N^+$ regions 5a and 5b located thereon so that they are well separated. This serves to prevent an unfavourable influence which would be exerted on the characteristic of the transistor region formed over the $P^+$ high concentration impurity layers 10a and 10b if those layers 10a and 10b were located with too small a spacing.

The $N^+$ region 5 b as the bit line and the $P^+$ high concentration impurity layer 10b, and the $N^+$ region 5b as the charge storage region and the $P^+$ high concentration impurity layer 10a are connected respectively by a PN junction. In this embodiment, the concentration at this PN junction is selected to be approximately $1 \times 10^{15}$ to $10^{17}/cm^3$. This concentration is selected so that extension of depletion layers in the $N^+$ regions 5a and 5b can be sufficiently suppressed and so that the dielectric strength of the PN junction is not deteriorated. If the concentration at the PN junction is $1 \times 10^{15}$ to $10^{17}/cm^3$ as described above, the impurity concentration value of the $P^+$ high concentration impurity layers 10a and 10b can be made to be a value ten times larger than the impurity concentration of the P type silicon substrate 6. Alternatively, the impurity concentration of the P type silicon substrate 6 may be $1 \times 10^{13}$ to $10^{16}/cm^3$ and the impurity concentration of the $P^+$ high concentration impurity layers 10a and 10b may be $1 \times 10^{14}$ to $10^{18}/cm^3$.

In the following, a process for manufacturing the memory cell shown in Figs. 1A and 1B will be described briefly.

First of all, there is provided a P type silicon substrate 6 having crystal orientation of [100] and specific resistance of approximately $10\Omega cm$ for use in an ordinary N channel MOS. Then, by a well known photolithographic process, regions other than the regions allotted to the charge storage region 5a and the bit line region 5b are covered with resist and by using the resist as a mask, a well known ion implantation technique is applied to implant boron (B) as P type impurity by $1 \times 10^{13}$ to $10^{14}/cm^2$ for 50K, whereby $P^+$ high concentration impurity layers 10a and 10b are formed. As the P type impurity, aluminum (Al) may be used instead of boron. Subsequently, by a well known vapor growth process, a substrate surface portion 9 of the same polarity as that of the P type silicon substrate 6 is grown to a thickness of approximately 1 to 2 μm.

The previously formed $P^+$ high concentration impurity layers 10a and 10b are extended into the substrate surface portion 9 at the time of forming the substrate surface portion 9 by the vapor growth process or in a heat treatment applied thereafter.

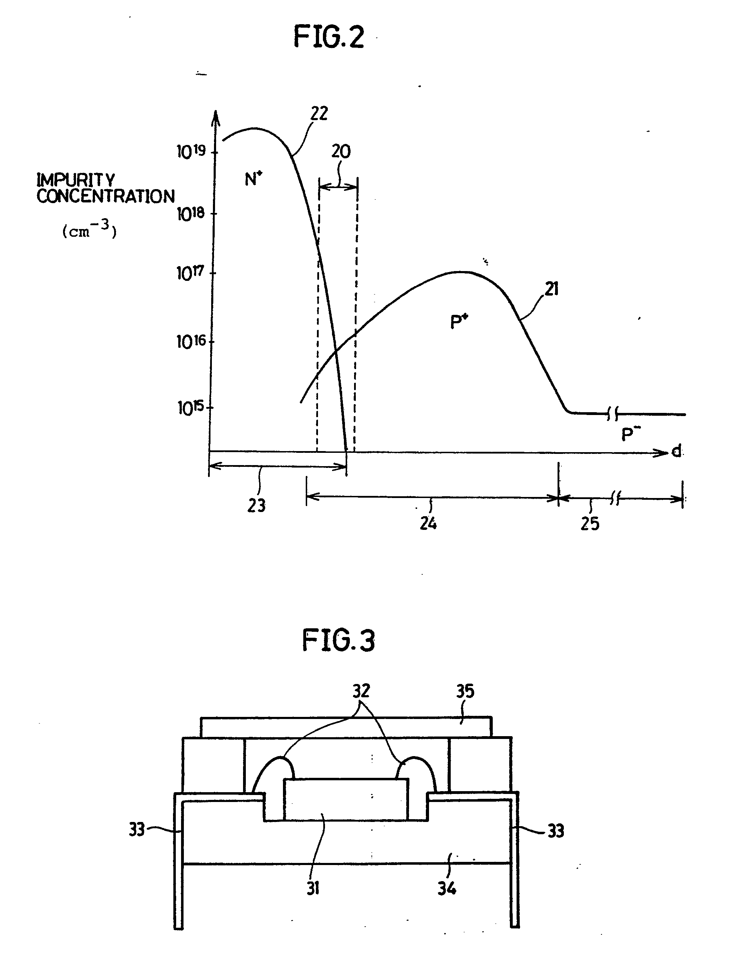

Referring now to Fig. 2, characteristics of the PN junctions between the $P^+$ high concentration impurity layers 10a and 10b and the $N^+$ regions 5a and 5b will be described. In Fig. 2, the numeral 20 indicates a PN junction region; 21 indicates a P impurity concentration curve; 22 indicates an N impurity concentration curve; 23 indicates the $N^+$ impurity diffusion regions 5a and 5b; 24 indicates the high concentration impurity layers 10a and 10b; and 25 indicates the region of the P type silicon substrate 6. The ordinate of the graph in Fig. 2 represents impurity concentration and the abscissa thereof represents a depth d from the surface of the substrate surface portion 9. As for the impurity concentration in the substrate surface portion 9, P type impurity is uniformly distributed in the regions other than the $N^+$ impurity diffusion regions 5a and 5b and the $P^+$ high concentration impurity layers 10a and 10b because P type impurity is little diffused from the silicon substrate 6 into those regions excluding the regions 5a and 5b and the layers 10a and 10b. As a result, the substrate surface portion 9 has a characteristic exerting no influence on the transistor characteristics and the like. Manufacturing of an oxide film, a polysilicon layer etc. formed on the above stated substrate surface portion 9 is made entirely in the same manner as in a conventional memory device.

Now, operation of the memory cell of the embodiment shown in Figs. 1A and 1B will be briefly described. Storage of electric charge in the $N^+$ region 5a as the charge storage region, namely, writing in memory is performed in the following manner. A voltage is applied to the second polysilicon layer 3 as the gate electrode of a writing transistor to conduct the writing transistor, whereby "1" or "0" is written in the capacitor including the charge storage region 5a. Then, the transistor is brought into a non conductive state to electrically disconnect the region 5a. Thus, a state in which data is written in the memory cell is established.

If α rays are applied, in this state, from an exterior, approximately $10^6$ electron-hole pairs per $cm^3$ are generated within a region extending from the surface of the silicon substrate 6 to approximately 25 μm. The holes out of these pairs are normaly absorbed in the silicon substrate 6 in the case of N channel MOS, while the electrons out of these pairs are diffused to approach the $N^+$ regions 5a and 5b. In a conventional memory cell, those electrons are collected into a charge storage region such as the $N^+$ region 5a as shown in Fig. 6A and as a result the potential stored in that region is changed to cause the stored content to be erased or to cause other erroneous operation. On the other hand, in this embodiment, depletion layers in the $N^+$ regions 5a and 5b extend little since the high concentration impurity layers 10a and 10b exist thereunder. In addition, lifetime of electrons passing through the high concentration impurity layers 10a and 10b is shortened and accordingly there are few electrons reaching the $N^+$ regions 5a and 5b. Thus, in this embodiment, there is little influence of the electric charge generated by α particles.

Although the foregoing description was made on the N channel MOS, the present invention is also applicable to a P channel MOS by changing the polarity and the like of the respective portions.

In addition, as the passivation film 7, a material of a low dielectric constant such as $SiO_2$ may be used.

Thus, since the high concentration impurity layers 10a and 10b serving as barriers are provided, it is unnecessary to adopt chip coating by resin or the like which has been used conventionally for protection against α particles and also no special manufacturing steps for packaging are needed. Consequently, the manufacturing process can be simplified and the manufacturing cost can be reduced.

Figs. 3 to 5 show examples in which a memory cell is contained in a package. As the package materials in the respective figures, well known materials are used and materials having a low emission ratio of α particles are not required. An α particle protection film does not need to be provided on the surface of the chip.

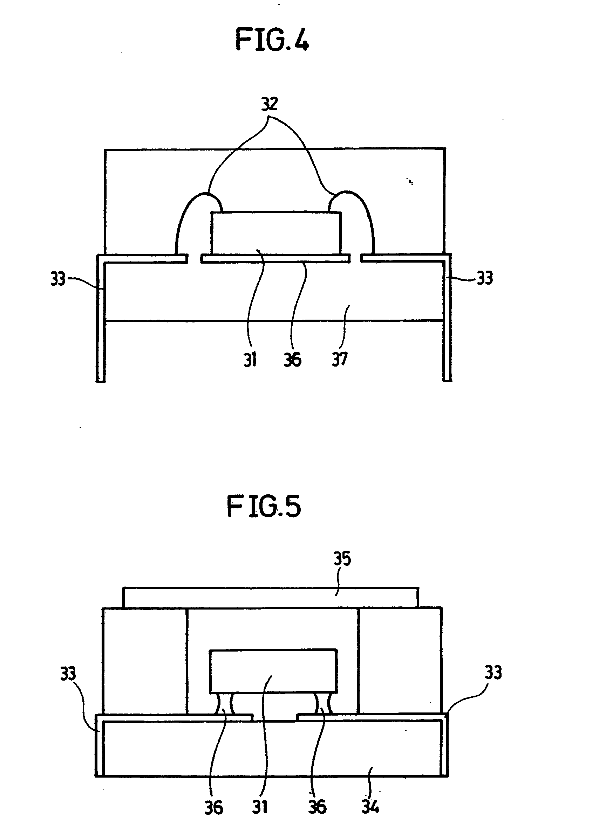

Fig. 3 shows an example in which a memory cell is contained in a ceramic package; Fig. 4 shows an example in which a memory cell is contained in a resin-mold package; and Fig. 5 shows an example in which a memory cell is contained by a flip chip system. Referring to Figs. 3 to 5, the reference numeral 31 denotes a memory chip; 32 denotes a bonding wire; 33 denotes external leads; 34 denotes a ceramic substrate; 35 denotes a cover; 36 denotes a frame; and 37 denotes a resin material. Though not shown, if a memory cell in accordance with the present invention is contained in a package of a SOJ type, a ZIP type or a module type, it is not necessary to provide an particle protection film on the chip surface nor to use special packaging material and thus the manufacturing process can be simplified and the manufacturing cost can be reduced.

**Claims**

1. A semiconductor memory device comprising:
   a semiconductor substrate (6) of a first conductivity type,
   a charge storage region (5a) formed in a surface region (9) of said semiconductor substrate, said charge storage region being of a second conductivity type,
   a bit line region (5b) for inputting and outputting electric charge stored in said charge storage region, said bit line region being of the second conductivity type and formed in the surface region (9) of said semiconductor substrate in the vicinity of said charge storage region,
   a first gate electrode (2) provided above the surface of said charge storage region,
   a second gate electrode (3) provided adjacent to the surface of said bit line region, and
   electrical insulation (4)
   between said charge storage region and said first gate electrode, between said bit line region and said second gate electrode, and between said first gate electrode and said second gate electrode,
   said semiconductor memory device further comprising,
   in said semiconductor substrate, high concentration impurity regions (10a and 10b) adjacent to said charge storage region and to said bit line region to form PN junctions with said charge storage region and with said bit line region, characterised in that the respective plane areas of said high concentration impurity regions (10a and 10b) extending along the plane direction of said semiconductor substrate (6) are smaller than, and do not extend beyond, the corresponding plane areas of said charge storage region (5a) and said bit line region (5b) located on said high concentration impurity regions (10a and 10b).

2. A semiconductor memory device in accordance with claim 1, wherein
   the impurity concentration of the first conductivity type of said high concentration impurity regions (10a and 10b) is more than ten times as high as the impurity concentration of said semiconductor substrate (6).

3. A semiconductor memory device in accordance with claim 2, wherein
the impurity concentration of said semiconductor substrate (6) is within a range of 1 x 10$^{13}$ to 10$^{16}$/cm$^3$ and the impurity concentration of said high concentration impurity regions (10a and 10b) is within a range of 1 x 10$^{14}$ to 10$^{18}$/cm$^3$.

4. A semiconductor memory device in accordance with claim 1, 2 or 3, wherein
the junction concentration of said PN junctions is within a range of 1 x 10$^{15}$ to 10$^{17}$/cm$^3$.

5. A semiconductor memory device in accordance with any preceding claim, wherein
said semiconductor substrate (6) is a P-type silicon substrate.

6. A semiconductor memory device in accordance with claim 5, wherein
said regions (5a and 5b) of the second conductivity type are formed as regions containing arsenic (As) or phosphorus (P) as impurity.

7. A semiconductor memory device in accordance with claim 6, wherein
said high concentration impurity regions (10a and 10b) are formed as regions containing boron (B) or aluminium (Al) as impurity.

**Revendications**

1. Un dispositif de mémoire à semiconducteurs, comprenant :
un substrat semiconducteur (6) d'un premier type de conductivité,
une région de stockage de charge (5a), formée dans une région de surface (9) du substrat semiconducteur, cette région de stockage de charge étant d'un second type de conductivité,
une région de ligne de bit (5b) pour introduire et extraire une charge électrique qui est stockée dans la région de stockage de charge, cette région de ligne de bit étant du second type de conductivité et étant formée dans la région de surface (9) du substrat semiconducteur, au voisinage de la région de stockage de charge,
une première électrode de grille (2) formée au-dessus de la surface de la région de stockage de charge,
une seconde électrode de grille (3) formée en position adjacente à la surface de la région de ligne de bit, et
une isolation électrique (4) entre la région de stockage de charge et la première électrode de grille, entre la région de ligne de bit et la seconde électrode de grille, et entre la première électrode de grille et la seconde électrode de grille,
ce dispositif de mémoire à semiconducteurs comprenant en outre, dans le substrat semiconducteur, des régions à forte concentration d' impureté (10a et 10b), adjacentes à la région de stockage de charge et à la région de ligne de bit, pour former des jonctions PN avec la région de stockage de charge et avec la région de ligne de bit, caractérisé en ce que les étendues en plan respectives des régions à forte concentration en impureté (10a et 10b), dans la direction du plan du substrat semiconducteur (6), sont plus petites que les étendues en plan correspondantes de la région de stockage de charge (5a) et de la région de ligne de bit (5b) qui sont situées sur les régions à forte concentration en impureté (10a et 10b), et elles ne s'étendent pas au-delà de celle-ci.

2. Un dispositif de mémoire à semiconducteurs selon la revendication 1, dans lequel
la concentration en impureté du premier type de conductivité des régions à forte concentration en impureté (10a et 10b), est supérieure à dix fois la concentration en impureté du substrat semiconducteur (6).

3. Un dispositif de mémoire à semiconducteurs selon la revendication 2, dans lequel
la concentration en impureté du substrat semiconducteur (6) est comprise dans une plage de 1 x 10$^{13}$ à 10$^{16}$/cm$^3$, et la concentration en impureté des régions à forte concentration en impureté (10a et 10b), est comprise dans une plage de 1 x 10$^{14}$ à 10$^{18}$/cm$^3$.

4. Un dispositif de mémoire à semiconducteurs selon les revendications 1, 2 ou 3, dans lequel
la concentration des jonctions PN est comprise dans une plage de 1 x 10$^{15}$ à 10$^{17}$/cm$^3$.

5. Un dispositif de mémoire à semiconducteurs selon l'une quelconque des revendications précédentes, dans lequel
le substrat semiconducteur (6) est un substrat en silicium de type P.

6. Un dispositif à semiconducteurs selon la revendication 5, dans lequel
les régions (5a et 5b) du second type de conductivité sont réalisées sous la forme de régions contenant de l'arsenic (As) ou du phosphore (P) à titre d'impureté.

7.   Un dispositif de mémoire à semiconducteurs selon la revendication 6, dans lequel
les régions à forte concentration en impureté (10a et 10b) sont réalisées sous la forme de régions contenant du bore (B) ou de l'aluminium (Al) à titre d'impureté.

**Patentansprüche**

1.   Halbleiterspeichereinrichtung mit:
einem Halbleitersubstrat (6) eines ersten Leitungstypes,
einem in einem Oberflächenbereich. (9) des Halbleitersubstrates gebildeten Ladungsspeicherbereich (5a), der einen zweiten Leitungstyp aufweist,
einem Bitleitungsbereich (5b) zum Eingeben und Ausgeben von in dem Ladungsspeicherbereich gespeicherter elektrischer Ladung, wobei der Bitleitungsbereich den zweiten Leitungstyp aufweist und in dem Oberflächenbereich (9) des Halbleitersubstrates benachbart zu dem Ladungsspeicherbereich gebildet ist,
einer oberhalb der Oberfläche des Ladungsspeicherbereiches vorgesehenen ersten Gate-Elektrode (2),
einer benachbart zu der Oberfläche des Bitleitungsbereiches vorgesehenen zweiten Gate-Elektrode (3) und
elektrischer Isolierung (4)
zwischen dem Ladungsspeicherbereich und der ersten Gate-Elektrode, zwischen dem Bitleitungsbereich und der zweiten Gate-Elektrode und zwischen der ersten Gate-Elektrode und der zweiten Gate-Elektrode,
wobei die Halbleiterspeichereinrichtung in dem Halbleitersubstrat weiter Hochkonzentrationsfremdatombereiche (10a und 10b) benachbart zu dem Ladungsspeicherbereich und dem Bitleitungsbereich zum Bilden von PN-Übergängen mit dem Ladungsspeicherbereich und mit dem Bitleitungsbereich aufweist, dadurch gekennzeichnet, daß die entsprechenden ebenen Flächen der Hochkonzentrationsfremdatombereiche (10a und 10b), die sich entlang der ebenen Richtung des Halbleitersubstrates (6) erstrecken, kleiner als die entsprechenden ebenen Flächen des Ladungsspeicherbereiches (5a) und des Bitleitungsbereiches (5b) sind, die auf den Hochkonzentrationsfremdatombereichen (10a und 10b) angeordnet sind, und sich nicht darüber hinaus erstrecken.

2.   Halbleiterspeichereinrichtung nach Anspruch 1, bei der die Fremdatomkonzentration des ersten Leitungstypes der Hochkonzentrationsfremdatombereiche (10a und 10b) mehr als zehnmal höher als die Fremdatomkonzentration des halbleitersubstrates (6) ist.

3.   Halbleiterspeichereinrichtung nach Anspruch 2, bei der die Fremdatomkonzentration des Halbleitersubstrates (6) in dem Bereich von $1 \times 10^{13}$ bis $10^{16}/cm^3$ liegt und die Fremdatomkonzentration der Hochkonzentrationsfremdatombereiche (10a und 10b) in dem Bereich von $1 \times 10^{14}$ bis $10^{18}/cm^3$ liegt.

4.   Halbleiterspeichereinrichtung nach Anspruch 1, 2 oder 3,
bei der Übergangskonzentration der PN-Übergänge in dem Bereich von $1 \times 10^{15}$ bis $10^{17}/cm^3$ liegt.

5.   Halbleiterspeichereinrichtung nach einem der vorhergehenden Ansprüche,
bei der das Halbleitersubstrat (6) ein P-Typ-Siliziumsubstrat ist.

6.   Halbleiterspeichereinrichtung nach Anspruch 5, bei der die Bereiche (5a und 5b) des zweiten Leitungstypes als Bereiche gebildet sind, die Arsen (As) oder Phosphor (P) als Fremdatome enthalten.

7.   Halbleiterspeichereinrichtung nach Anspruch 6, bei der die Hochkonzentrationsfremdatombereiche (10a und 10b) als Bereiche gebildet sind, die Bor (B) oder Aluminium (Al) als Störatome enthalten.

# FIG.1A

# FIG.1B

## FIG.2

IMPURITY
CONCENTRATION
$(cm^{-3})$

$10^{19}$

$10^{18}$

$10^{17}$

$10^{16}$

$10^{15}$

$N^+$

$P^+$

$P^-$

d

22

20

21

23

24

25

## FIG.3

32

35

33

33

31

34

# FIG.4

# FIG.5

## FIG.6A

## FIG.6B